# EUROPEAN PATENT SPECIFICATION

(11) **EP 2 508 897 B1**
(45) Date of publication and mention of the grant of the patent: **10.01.2018**
(21) Application number: 10833342.8
(22) Date of filing: 26.11.2010
(51) Int. Cl.: G01D 4/00, G01R 21/133

(54) **POWER CONSUMPTION MEASUREMENT SYSTEM, OUTLET DEVICE, CONTROL DEVICE, MEASURING DEVICE, AND POWER CONSUMPTION MEASURING METHOD**
SYSTEM ZUM MESSEN DES STROMVERBRAUCHS, BUCHSENVORRICHTUNG, STEUERVORRICHTUNG, MESSVORRICHTUNG UND VERFAHREN ZUM MESSEN DES STROMVERBRAUCHS
SYSTÈME DE MESURE DE LA CONSOMMATION D'ÉLECTRICITÉ, DISPOSITIF DE PRISE, DISPOSITIF DE COMMANDE, DISPOSITIF DE MESURE ET PROCÉDÉ DE MESURE DE LA CONSOMMATION D'ÉLECTRICITÉ

(30) Priority: 30.11.2009 JP 2009272987
(43) Date of publication of application: 10.10.2012
(73) Proprietor: Kyocera Corporation, Kyoto-shi, Kyoto 612-8501 (JP)
(72) Inventor: KIUCHI, Kazuya, Tokyo 158-8610 (JP); KUSAFUKA, Kaoru, Tokyo 158-8610 (JP); WATANABE, Tadayuki, Tokyo 158-8610 (JP); SHICHIRI, Kazumasa, Tokyo 158-8610 (JP); IWABUCHI, Akinori, Kanagawa 224-8502 (JP)
(74) Representative: Schwabe - Sandmair - Marx
(86) International application number: PCT/JP2010/071152
(87) International publication number: WO 2011/065497

(56) References cited:
- WO-A1-2004/102212
- DE-A1-102007 047 920
- JP-A- 2001 298 877
- JP-A- 2003 259 569
- JP-A- 2006 337 193
- JP-A- 2008 079 410
- JP-A- 2008 306 809
- JP-A- 2009 026 305
- HART G W: "NONINTRUSIVE APPLIANCE LOAD MONITORING", PROCEEDINGS OF THE IEEE, IEEE. NEW YORK, US, vol. 80, no. 12, 1 December 1992 (1992-12-01), pages 1870-1891, XP000336363, ISSN: 0018-9219, DOI: 10.1109/5.192069
- NAJMEDDINE H ET AL: "State of art on load monitoring methods", POWER AND ENERGY CONFERENCE, 2008. PECON 2008. IEEE 2ND INTERNATIONAL, IEEE, PISCATAWAY, NJ, USA, 1 December 2008 (2008-12-01), pages 1256-1258, XP031413104, ISBN: 978-1-4244-2404-7
- HSUEH-HSIEN CHANG ET AL: "Load recognition for different loads with the same real power and reactive power in a non-intrusive load-monitoring system", COMPUTER SUPPORTED COOPERATIVE WORK IN DESIGN, 2008. CSCWD 2008. 12TH INTERNATIONAL CONFERENCE ON, IEEE, PISCATAWAY, NJ, USA, 16 April 2008 (2008-04-16), pages 1122-1127, XP031269021, ISBN: 978-1-4244-1650-9
- LAM H Y ET AL: "A Novel Method to Construct Taxonomy Electrical Appliances Based on Load Signaturesof", IEEE TRANSACTIONS ON CONSUMER ELECTRONICS, IEEE SERVICE CENTER, NEW YORK, NY, US, vol. 53, no. 2, 1 May 2007 (2007-05-01), pages 653-660, XP011186790, ISSN: 0098-3063, DOI: 10.1109/TCE.2007.381742
- CHENG J W M ET AL: "Electric-Load Intelligence (E-LI): Concept and Applications", TENCON 2006. 2006 IEEE REGION 10 CONFERENCE, IEEE, PI, 14 November 2006 (2006-11-14), pages 1-4, XP031333255, ISBN: 978-1-4244-0548-0
- COLE A I ET AL: "Data extraction for effective non-intrusive identification of residential power loads", INSTRUMENTATION AND MEASUREMENT TECHNOLOGY CONFERENCE, 1998. IMTC/98. CONFERENCE PROCEEDINGS. IEEE ST. PAUL, MN, USA 18-21 MAY 1998, NEW YORK, NY, USA,IEEE, US, vol. 2, 18 May 1998 (1998-05-18), pages 812-815, XP010281749, DOI: 10.1109/IMTC.1998.676838 ISBN: 978-0-7803-4797-7

## Description

### TECHNICAL FIELD

The present invention relates to a power consumption measurement system, an outlet device, a control device, a measuring device, and a power consumption measuring method for measuring the amount of power consumption.

### BACKGROUND ART

Due to an increase in the awareness of global environment problems, the introduction of renewable forms of energy such as photovoltaic cell (PV) is progressing. There is a problem that when PV, in which power generation varies depending on meteorological conditions, is interconnected with an electric power system in large quantities, it adversely affects the stable supply of the electric power system. In order to resolve this problem, the "Smart grid technologies" that make use of the information and communications technology and incorporate consumer to effectively control the electric power draw attention.

According to the smart grid technologies, in order to effectively control the electric power, it is important to measure the amount of power consumption associated with a consumer of electric power (hereinafter, simply referred to as a consumer). As a power consumption measurement system for measuring the amount of power consumption, there is known a configuration in which a current sensor is provided in the distribution board of the consumer, and the amount of power consumption of the consumer is measured by using the current sensor is known (for example, see Patent Document 1). The distribution board is provided at the branch point of the main line from the electric power system and the branching line in the wiring network of the consumer.

DE102007047920A1 discloses a device for detecting electrical energy of an electrical load and transmitting data relating to the load to a central server and receiving control data therefrom.

NAJMEDDINE H ET AL: "State of art on load monitoring methods",POWER AND ENERGY CONFERENCE, 2008. PECON 2008. IEEE 2ND INTERNATIONAL, IEEE, PISCATAWAY, NJ, USA, 1 December 2008 (2008-12-01), pages 1256-1258, XP031413104,ISBN: 978-1-4244-2404-7, describes methods of identifying loads by analyzing their time-dependent power consumption signals.

### PRIOR ART DOCUMENT

### PATENT DOCUMENT

Patent Document 1: Japanese Unexamined Patent Application Publication No. H11-313441

### SUMMARY OF THE INVENTION

However, according to the conventional power consumption measurement system, the electric current supplied to a plurality of loads (devices) is detected collectively by the current sensor, and it is difficult to determine that the electric current flowing across the distribution board is supplied to which load in a consumer.

Therefore, the conventional power consumption measurement system has a problem that although the amount of power consumption of each consumer can be measured, it is difficult to measure the amount of power consumption of each load in a consumer.

Therefore, an object of the present invention to provide a power consumption measurement system, an outlet device, a control device, a measuring device, and a power consumption measuring method, by which it is possible to easily measure the amount of power consumption of each load.

To solve the above problem, the present invention has following features. A first feature of the present invention is summarized as a power consumption measurement system, comprising: an outlet device (outlet device 100) provided in a consumer (consumer 1); and a measurement unit (power consumption amount measurement unit 122) configured to measure the amount of power consumption associated with the consumer, wherein the outlet device comprises: a feeding unit (feeding unit 101), connected to a load (load 50) within the consumer, configured to supply power to the connected load; and a detection unit (sensor circuit 110) configured to detect the amount of electric current flowing from the feeding unit to the load, wherein the measurement unit measures the amount of power consumption of each load depending on the amount of electric current detected by the detection unit.

According to the feature above, because the amount of electric current flowing from an outlet device to a load is detected directly, and the amount of power consumption is measured according to the amount of electric current, rather than the amount of power consumption of each consumer, the amount of power consumption of each load can be measured easily.

A second feature of the present invention according to the first feature is summarized as the power consumption measurement system, comprising: an analyzing unit (frequency analyzing unit 122) configured to acquire a frequency pattern by converting the time waveform of the amount of electric current detected by the detection unit to a frequency domain; a first storage unit (identification information storage unit 241) configured to store the frequency pattern of each load associating with the load identification information for identifying the load; and a search unit (identification information search unit 231) configured to search the load identification information corresponding to the frequency pattern acquired by the analyzing unit from the first storage unit.

A third feature of the present invention according to the second feature is summarized as the power consumption measurement system, comprising: a second storage unit (power consumption amount storage unit 242) configured to store the amount of power consumption measured by the measurement unit, associating with the load identification information searched by the search unit and the time information indicating the current time.

A fourth feature of the present invention according to the third feature is summarized as the power consumption measurement system, comprising: a display control unit (display control unit 233) configured to control so as to display the amount of power consumption, the load identification information, and the time information stored by the second storage unit associated each other.

A fifth feature of the present invention according to the second feature is summarized as that the first storage unit and the search unit are provided in a control device (control device 200) within the consumer, and the search unit requests a device outside the control device to search the load identification information corresponding to the frequency pattern acquired in the analyzing unit, when the load identification information corresponding to the frequency pattern acquired by the analyzing unit cannot be searched from the first storage unit.

A sixth feature of the present invention is summarized as an outlet device provided in a consumer, comprising: a feeding unit, connected to a load within the consumer, configured to supply power to the connected load; and a detection unit configured to detect the amount of electric current flowing from the feeding unit to the load; and a measurement unit configured to measure the amount of power consumption of each load depending on the amount of electric current detected by the detection unit.

A seventh feature of the present invention is summarized as the outlet device, comprising: an analyzing unit configured to acquire a frequency pattern by converting the time waveform of the amount of electric current detected by the detection unit to a frequency domain.

An eighth feature of the present invention is summarized as a control device, comprising: an analyzing unit configured to convert the time waveform of the amount of electric current flowing from the outlet device to the load to a frequency domain to acquire a frequency pattern; a first storage unit configured to store the frequency pattern of each load associated with the load identification information for identifying the load; and a search unit configured to search the load identification information corresponding to the frequency pattern acquired by the analyzing unit from the first storage unit.

A ninth feature of the present invention is summarized as a measuring device (measuring device 500) that can be connected to an outlet device, comprising: a feeding unit, connected to a load within the consumer, configured to supply power to the connected load; a detection unit configured to detect the amount of electric current flowing from the feeding unit to the load; a measurement unit configured to measure the amount of power consumption of each load depending on the amount of electric current detected by the detection unit; and an analyzing unit configured to convert the time waveform of the amount of electric current detected by the detection unit to a frequency domain to acquire a frequency pattern.

A tenth feature of the present invention is summarized as a power consumption measuring method, comprising: a step of supplying power to a load connected to an outlet device provided in a consumer by the outlet device; a step of detecting the amount of electric current flowing from the outlet device to the load by the outlet device; and a step of measuring the amount of power consumption of each load depending on the amount of electric current detected by the step of detecting.

According to the present invention, it is possible to provide a power consumption measurement system, an outlet device, a control device, a measuring device, and a power consumption measuring method, by which it is possible to easily measure the amount of power consumption of each load.

### BRIEF DESCRIPTION OF THE DRAWINGS

[Fig. 1] Fig. 1 is a diagram showing a schematic configuration of a power consumption measurement system according to an embodiment of the present invention.
[Fig. 2] Fig. 2 is a diagram for explaining a schematic configuration of an outlet device according to the embodiment of the present invention.
[Fig. 3] Fig. 3 is a block diagram showing a detailed configuration of the outlet device according to the embodiment of the present invention.
[Fig. 4] Fig. 4 is a diagram for explaining the frequency analysis process according to the embodiment of the present embodiment.
[Fig. 5] Fig. 5 is a block diagram showing a detailed configuration of a control device according to the embodiment of the present invention.
[Fig. 6] Fig. 6 is a flowchart showing an operation of the outlet device according to the embodiment of the present invention.
[Fig. 7] Fig. 7 is a flowchart showing an operation of the control device according to the embodiment of the present invention.
[Fig. 8] Fig. 8 is a block diagram showing a configuration of a control device according to a modification of the embodiment of the present invention.
[Fig. 9] Fig. 9 is a diagram showing a configuration of a measuring device according to a modification of the embodiment of the present invention.

### MODES FOR CARRYING OUT THE INVENTION

Next, an embodiment of the power consumption measurement system of the present invention is explained with reference to drawings. Specifically, (1) Schematic configuration of power consumption measurement system, (2) Detailed configuration of power consumption measurement system, (3) Operation of power consumption measurement system, (4) Effect of embodiment, (5) First modification, (6) Second modification, and (7) Other embodiments are explained.

In all drawings for explaining the following embodiments, the same or similar reference numerals are used to designate the same or similar elements.

### (1) Schematic configuration of power consumption measurement system

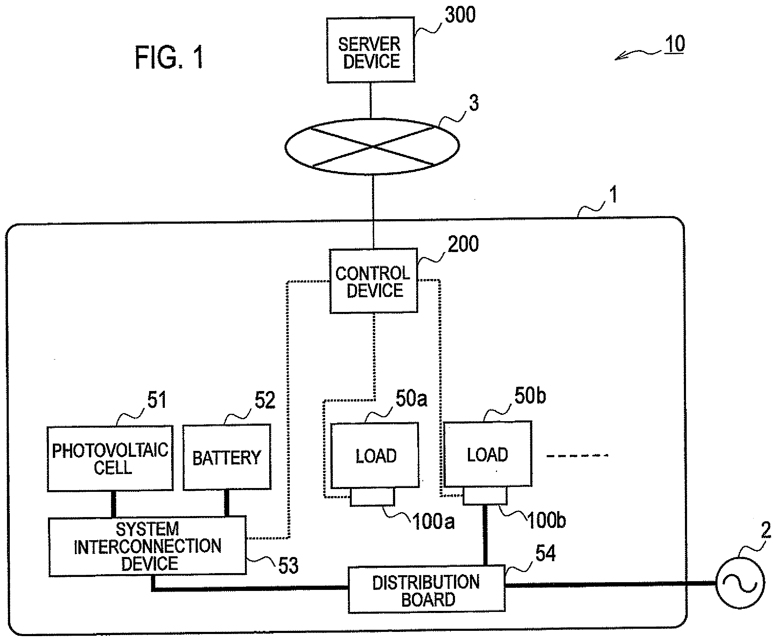

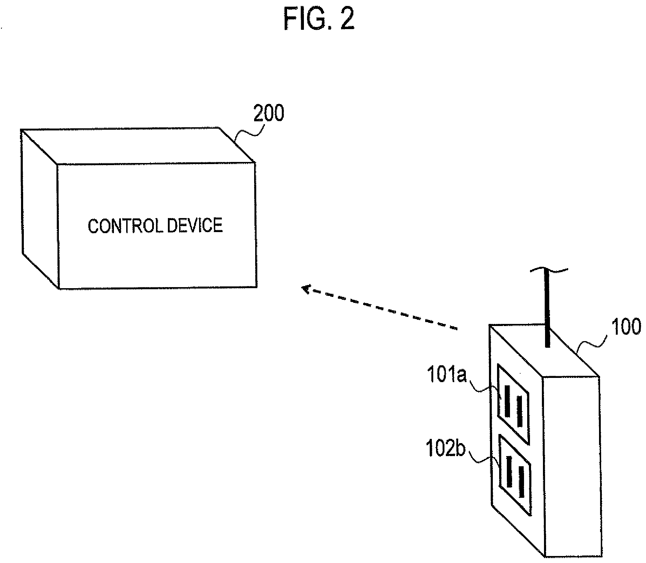

First of all, the schematic configuration of the power consumption measurement system according to the present embodiment is explained with reference to Fig. 1 and Fig. 2. Fig. 1 is a diagram showing a schematic configuration of the power consumption measurement system according to the present embodiment.

As shown in Fig. 1, AC power is supplied to a consumer 1 from a power system 2. The consumer 1 includes a photovoltaic cell 51, a battery 52, a system interconnection device 53, a distribution board 54, loads 50a, 50b, ..., outlet devices 100a, 100b, ..., and a control device 200.

The photovoltaic cell 51 receives solar light, and generates DC power in accordance with the received solar light. The battery 52 stores the electric power generated by the photovoltaic cell 51 and the electric power supplied from the power system 2.

The system interconnection device 53 performs conversion between AC and DC power. Specifically, the system interconnection device 53 converts the DC power from the photovoltaic cell 51 and the battery 52 to AC power, and interconnects with the power system 2.

The distribution board 54 distributes the AC power from the system interconnection device 53 and the power system 2 to loads 50a, 50b, ... via the outlet devices 100a, 100b, ....

Loads 50a, 50b, ... are devices consuming electric power, for example, household electrical appliances. The outlet devices 100a, 100b, ... are connected to loads 50a, 50b, ... and supply power to loads 50a, 50b, .... Hereinafter, any one of loads 50a, 50b, ... is appropriately called "load 50". Furthermore, any one of the outlet devices 100a, 100b, ... is appropriately called "outlet device 100".

The control device 200 performs power control in the consumer 1. The control device 200 communicates with the outlet device 100 and the system interconnection device 53. The communications can be radio communications or wire communications. In the case of radio communications, for example, Zigbee, which is one of the short-range radio communications standards for household electric appliances, can be used. In the case of wire communications, for example, PLC (Power Line Communications), which is a technique in which a power line is used as a communication line, can be used.

The control device 200 can communicate with a server device 300 via a wide area communication network 3 (for example, the Internet). The server device 300, for example, provides information for power control to the control device 200.

Fig. 2 is a diagram for explaining a schematic configuration of the outlet device 100.

The outlet device 100 is provided on the wall surface in the consumer 1, for example. As shown in Fig. 2, the outlet device 100 includes feeding units 101a and 101b. In the example shown in Fig. 2, two feeding units 101a and 101b are illustrated, however, the number of feeding units can be one or can be three or more. Hereinafter, any one of the feeding units 101a and 101b is appropriately called "feeding unit 101". The outlet device 100 measures the amount of power consumption of load 50 that is connected to the feeding unit 101, and notifies the measured amount of power consumption to the control device 200.

### (2) Detailed configuration of power consumption measurement system

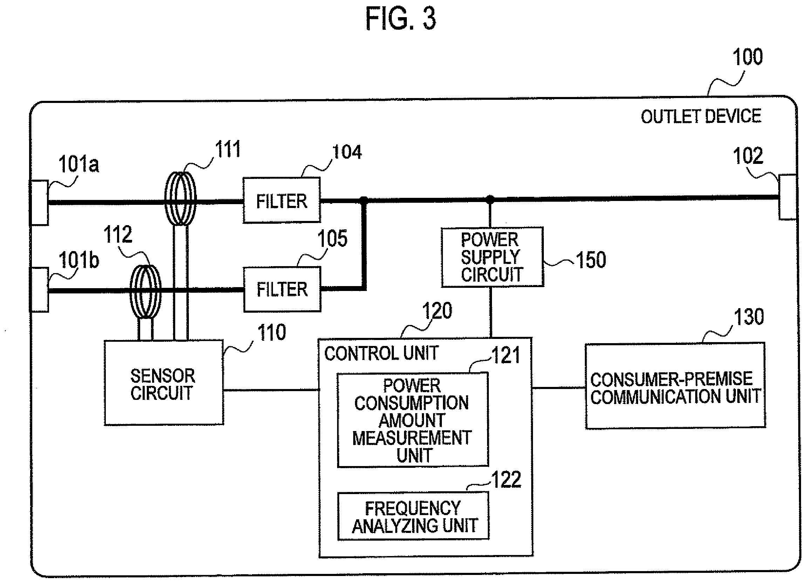

Next, the detailed configuration of the power consumption measurement system is explained with reference to Fig. 3 through Fig. 5. Specifically, the (2.1) Detailed configuration of outlet device, and the (2.2) Detailed configuration of control device are explained.

### (2.1) Detailed configuration of outlet device

Fig. 3 is a block diagram showing the detailed configuration of the outlet device 100.

As shown in Fig. 3, the outlet device 100 includes the feeding units 101a and 101b, a power receiving unit 102, filters 104 and 105, coils 111 and 112, a sensor circuit 110, a control unit 120, and a consumer-premise communication unit 130.

The power receiving unit 102 receives AC power from the distribution board 54. Filters 104 and 105 remove the noise components included in the power received by the power receiving unit 102.

Different loads 50 are connected to each of the feeding units 101a and 101b. Each of the feeding units 101a and 101b supplies power to loads 50.

The coil 111 detects the amount of electric current flowing to load 50 connected to the feeding unit 101a. Specifically, the coil 111 outputs the electric current proportional to the amount of electric current flowing to load 50 connected to the feeding unit 101a. Similarly, the coil 112 detects the amount of electric current flowing to load 50 connected to the feeding unit 101b.

In the sensor circuit 110, electric current is input from coils 111 and 112. The sensor circuit 110 generates a sensor signal indicating the amount of electric current flowing to loads 50 connected to each of the feeding units 101a and 101b, and inputs the sensor signal to the control unit 120. Furthermore, the sensor circuit 110 operates depending on the power from the power supply circuit 150 provided between the feeding units 101a and 101b and the power receiving unit 102.

The control unit 120 is configured using a microcomputer, for example, and performs control associated with the outlet device 100. The control unit 120 includes a power consumption amount measurement unit 121 and a frequency analyzing unit 122.

The power consumption amount measurement unit 121 measures the amount of power consumption of each of the loads 50 connected to each of the feeding units 101a and 101b depending on the sensor signal from the sensor circuit 110. The power consumption amount measurement unit 121 can measure (calculate) the amount of power consumption based on the amount of electric current indicated by the sensor signal and the electric voltage in the power supply circuit 150.

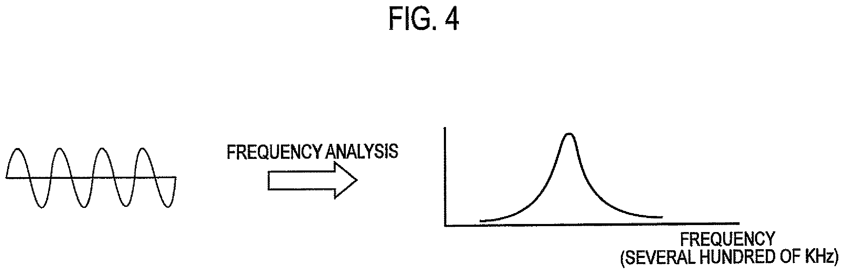

As shown in Fig. 4, the frequency analyzing unit 122 acquires a frequency pattern by converting the time waveform of the amount of power consumption of each of the loads 50 connected to each of the feeding units 101a and 101b to a frequency domain depending on the sensor signal from the sensor circuit 110. After performing A/D conversion of the sensor signal, the frequency analyzing unit 122 performs the FFT (Fast Fourier Transform) process, and derives a frequency waveform.

The amount of power consumption measured by the power consumption amount measurement unit 121 and the frequency pattern acquired by the frequency analyzing unit 122 is transmitted to the control device 200 from the consumer-premise communication unit 130 in predetermined time intervals (for example, in every 1 to 60 minutes). Note that the communication method of the consumer-premise communication unit 130 can be a unique method or a method conforming to ECHONET (Energy Conservation and Homecare Network).

### (2.2) Detailed configuration of control device

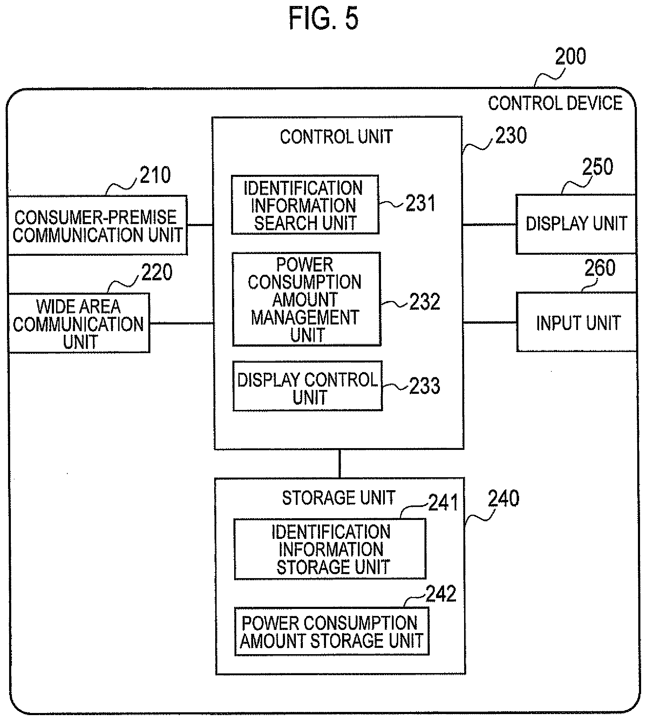

Fig. 5 is a block diagram showing the detailed configuration of the control device 200.

As shown in Fig. 5, the control device 200 includes a consumer-premise communication unit 210, a wide area communication unit 220, a control unit 230, a storage unit 240, a display unit 250, and an input unit 260.

The consumer-premise communication unit 210 communicates with the outlet device 100 and the system interconnection device 53. As described above, the communication method of the consumer-premise communication unit 210 can be a unique communication method or a method conforming to ECHONET. The wide area communication unit 220 communicates with the server device 300 via the wide area communication network 3.

The control unit 230 is configured using a CPU, for example, and performs control associated with the control device 200. The storage unit 240 is configured using a semiconductor memory or a hard disk drive, for example, and stores the information associated with the control performed by the control device 230.

The display unit 250 displays images under the control of the control unit 230. The input unit 260 receives the input from the user. Note that the display unit 250 and the input unit 260 may be stored in a housing separate from the housing in which the control unit 230 and the storage unit 240 are stored. That is, the display unit 250 and the input unit 260 may be configured as remote controllers. Furthermore, the display unit 250 and the input unit 260 may be configured as a touch panel in the form of a single unit.

The control unit 230 includes an identification information search unit 231, a power consumption amount management unit 232, and a display control unit 233. The storage unit 240 includes an identification information storage unit 241 and a power consumption amount storage unit 242.

The identification information storage unit 241 stores the frequency pattern of each load 50 associated with the load identification information for identifying the load 50. The load identification information is information about the name, model, or type of loads (devices). For example, the configuration may be such that the user registers beforehand the typical frequency pattern of the load along with the load identification information in the identification information storage unit 241.

The identification information search unit 231 searches from the identification information storage unit 241 the load identification information corresponding to the frequency pattern received by the consumer-premise communication unit 210 from the outlet device 100. Specifically, the identification information search unit 231 performs pattern matching between the frequency pattern received from the outlet device 100 and each frequency pattern stored in the identification information storage unit 241, and acquires the load identification information corresponding to the frequency pattern having the highest match with the frequency pattern received from the outlet device 100 from the identification information storage unit 241. As a result of such process, even when a load is carried from one room to another, for example, the load can be determined by the control device 200.

The power consumption amount management unit 232 stores: the amount of power consumption received by the consumer-premise communication unit 210 from the outlet device 100, associated with the load identification information searched by the identification information search unit 231 and the time information indicating the current time, in the power consumption amount storage unit 242. That is, the power consumption amount management unit 232 creates a log of the amount of power consumption of each load.

The display control unit 233 performs a display corresponding to an instruction from the user in the display unit 250. The display control unit 233 adds up the logs stored by the power consumption amount storage unit 242 following which the display control unit 233 displays a graph in the display unit 250, and realizes the so-called "visibility" of the amount of power consumption.

For example, by graphing the amount of power consumption of each type of load in each time zone of a day, the user can easily comprehend the amount of power consumed in each time zone.

In the aforementioned example, it was explained on the assumption that the identification information search unit 231 can search from the identification information storage unit 241 the load identification information corresponding to the frequency pattern received by the consumer-premise communication unit 210 from the outlet device 100, however, this is not applicable when a new load (device) is connected to the outlet device 100.

When a new load is connected, and the identification information search unit 231 detects an unknown frequency pattern, the frequency pattern can be determined after the user inputs the load identification information in the input unit 260 of the control device 200. In such a case, the display control unit 233 may perform a display for prompting the user to input the load identification information in the display unit 250.

Alternatively, when a new load is connected and the identification information search unit 231 detects an unknown frequency pattern, the identification information search unit 231 may request the server device 300 to search the load identification information corresponding to the unknown frequency pattern. At that time, the identification information search unit 231 transmits the unknown frequency pattern or information equivalent to the frequency pattern (for example, a consumption current waveform) from the wide area communication unit 220 to the server device 300. The server device 300 includes the database of the frequency pattern, searches the load identification information depending on the request from the control device 200, and transmits the search results to the control device 200. The power consumption amount management unit 232 stores the load identification information received from the server device 300 in the storage unit 240. As a result of such process, the load identification information can be set automatically without user input.

### (3) Operation of power consumption measurement system

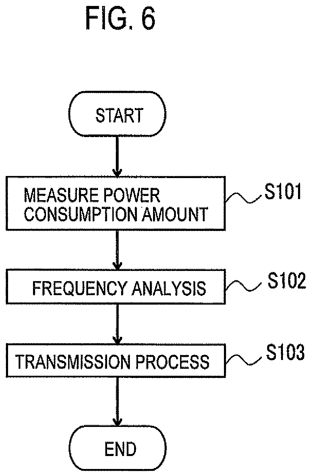

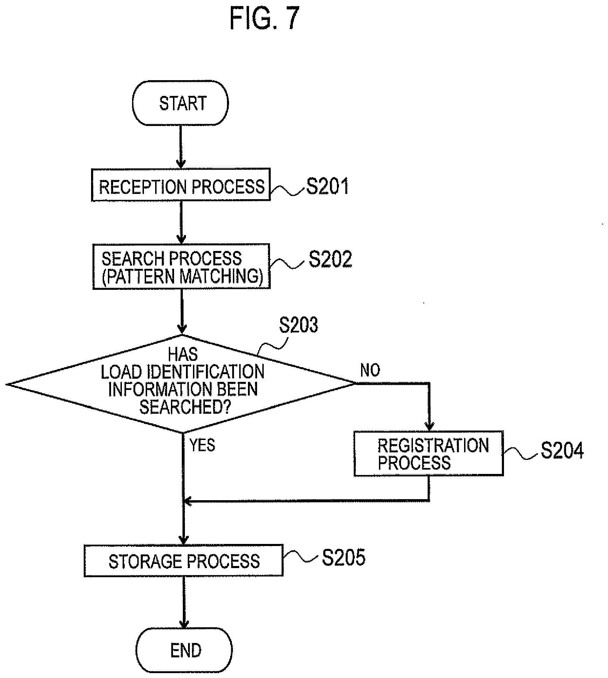

Next, the operation of the power consumption measurement system is explained with reference to Fig. 6 and Fig. 7. Specifically, the (3.1) Operation of outlet device, and the (3.2) Operation of control device are explained.

### (3.1) Operation of outlet device

Fig. 6 is a flowchart showing an operation of the outlet device 100.

In step S101, the power consumption amount measurement unit 121 measures the amount of power consumption of each of the loads 50 connected to the feeding unit 101 depending on the sensor signal from the sensor circuit 110.

In step S102, the frequency analyzing unit 122 acquires a frequency pattern by converting the time waveform of the amount of power consumption of each of the loads 50 connected to the feeding unit 101 to a frequency domain depending on the sensor signal from the sensor circuit 110.

In step S103, the consumer-premise communication unit 130 transmits the amount of power consumption measured by the power consumption amount measurement unit 121 and the frequency pattern acquired by the frequency analyzing unit 122 to the control device 200 in predetermined time intervals.

### (3.2) Operation of control device

Fig. 7 is a flowchart showing an operation of the control device 200.

In step S201, the consumer-premise communication unit 210 receives the amount of power consumption and the frequency pattern from the outlet device 100.

In step S202, the identification information search unit 231 searches from the identification information storage unit 241 the load identification information corresponding to the frequency pattern received by the consumer-premise communication unit 210 from the outlet device 100. When the load identification information corresponding to the frequency pattern received from the outlet device 100 is searched (step S203; YES), the process proceeds to step S205, and when the load identification information is not searched (step S203; NO), the process proceeds to step S204.

In step S205, the power consumption amount management unit 232 stores: the amount of power consumption received by the consumer-premise communication unit 210 from the outlet device 100 associated with the load identification information searched by the identification information search unit 231 and the time information indicating the current time, in the power consumption amount storage unit 242.

In step S204, the display control unit 233 performs a display for prompting the user to input the load identification information corresponding to the unknown frequency pattern in the display unit 250. Alternatively, the identification information search unit 231 requests the server device 300 to search the load identification information corresponding to the unknown frequency pattern. The load identification information thus acquired is stored and associated with the unknown frequency pattern, in the identification information storage unit 241.

### (4) Effect of embodiment

As explained above, according to the present embodiment, because the sensor circuit 110 directly detects the amount of electric current flowing from the outlet device 100 to the load 50, and measures the amount of power consumption according to the amount of electric current, rather than the amount of power consumption of each consumer, the amount of power consumption of each load can be measured easily.

According to the present embodiment, the identification information search unit 231 can automatically determine the attributes of load 50 (such as the name, model, and type) by searching the load identification information corresponding to the frequency pattern acquired by the frequency analyzing unit 122 from the identification information storage unit 241.

According to the present embodiment, the power consumption amount storage unit 242 stores: the amount of power consumption measured by the power consumption amount measurement unit 122 associated with the load identification information searched by the identification information search unit 231 and the time information indicating the current time. Thus, the transition in the amount of power consumption of each attribute of the load can be recorded.

According to the present embodiment, the display control unit 233 controls so as to display the amount of power consumption, the load identification information, and the time information stored in the second storage unit associated each other displayed. According to such display control, the transition in the amount of power consumption of each attribute of the load can be checked by the user.

According to the present embodiment, when the load identification information corresponding to the frequency pattern acquired by the frequency analyzing unit 122 is not searched from the identification information storage unit 241, the identification information search unit 231 requests the server device 300 to search the load identification corresponding to the frequency pattern acquired by the frequency analyzing unit 122. Thus, even when a load that is unknown to the control device 200 is connected to the outlet device 100, the attributes of the load can be determined.

### (5) First Modification

According to the aforementioned embodiment, the frequency analysis process was performed in the outlet device 100, however, a sensor signal can be notified from the outlet device 100 to the control device 200, and the frequency analysis process can be performed in the control device 200. Specifically, the consumer-premise communication unit 130 of the outlet device 100 transmits the sensor signal after A/D conversion to the control device 200 only during the period of frequency analysis.

Furthermore, according to the present embodiment, the amount of power consumption was measured in the outlet device 100, however, a sensor signal can be notified from the outlet device 100 to the control device 200, and the amount of power consumption can be measured in the control device 200.

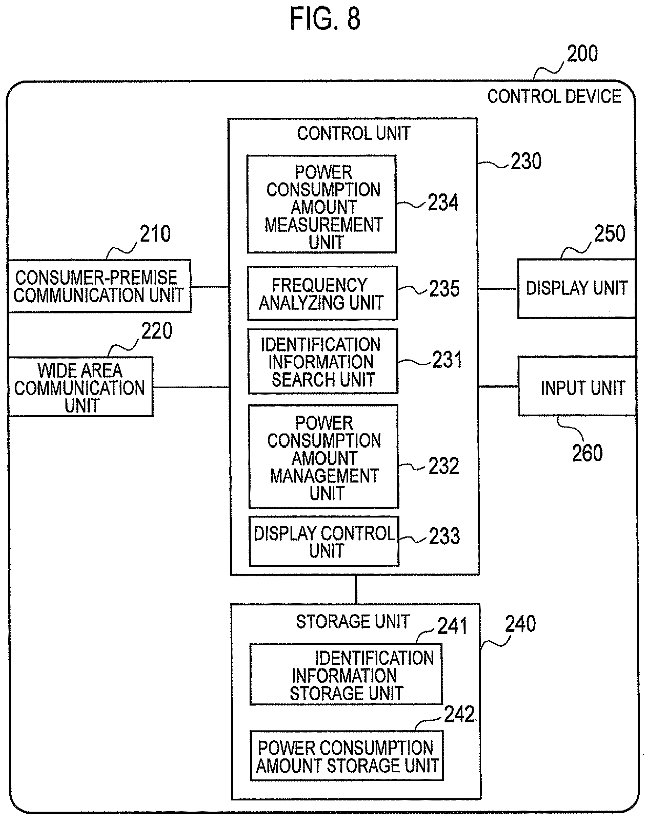

Fig. 8 is a block diagram showing a configuration of the control device 200 according to a modification. As shown in Fig. 8, the control device 200 includes a power consumption amount measurement unit 234 configured to measure the amount of power consumption, and a frequency analyzing unit 235 configured to perform frequency analysis. The configurations besides this are same as the aforementioned embodiment.

### (6) Second modification

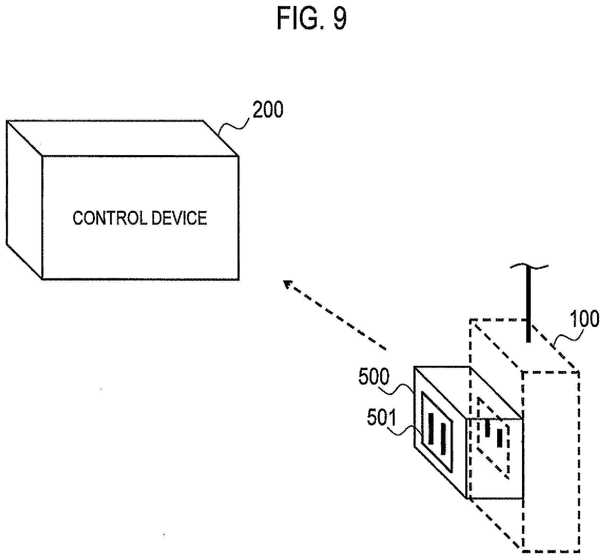

In the aforementioned embodiment, the outlet device 100 performs the measurement of the amount of power consumption and the frequency analysis; however, as shown in Fig. 9, a measuring device 500 that can be connected to the outlet device 100 can perform measurement of the amount of power consumption and frequency analysis. The measuring device 500 includes a feeding unit 501 connected to the load 50. The measuring device 500 includes the same internal configuration as Fig. 3.

### (7) Other embodiments

As described above, the present invention has been described with the embodiments. However, it should not be understood that those descriptions and drawings constituting a part of the present disclosure limit the present invention. From this disclosure, a variety of alternate embodiments, examples, and applicable techniques will become apparent to one skilled in the art.

For example, according to the aforementioned embodiment, a configuration displaying the measured amount of power consumption is illustrated, however, the measured amount of power consumption can be used not only for display purpose but in various existing power controls (for example, power consumption control of load 50 and discharge and charge control of the battery 52).

Furthermore, in addition to the above embodiments, the server device 300 can include the below functions. Specifically, the server device 300 can manage the information about the load (devices) that each of a plurality of consumers includes, and can use this information in services such as the advertising service and device maintenance.

Note that in the aforementioned embodiment, a photovoltaic cell 51 was illustrated as an example of a DC power source, however, not only a photovoltaic cell 51, but, for example, a fuel cell can also be used.

Thus, it must be understood that the present invention includes various embodiments that are not described herein. Therefore, the present invention is limited only by the specific features of the invention in the scope of the claims reasonably evident from the disclosure above.

### INDUSTRIAL APPLICABILITY

As described above, according to the radio communication system, the network-side device, the small cell base station, and the transmission power control method of the present invention, even when the number of small cell base stations in a large cell changes, the present invention is useful in radio communications such as mobile communications because a decline in the communication speed of the radio terminal connected to a large cell base station can be prevented.

As described above, according to the power consumption measurement system, the outlet device, the control device, the measuring device, and the power consumption measuring method of the present invention, because the amount of power consumption of each load can be measured easily, the present invention is useful.

## Claims

1. A power consumption measurement system (10) for measuring the amount of power consumption of a plurality of loads (50) provided in a consumer premise, comprising:
an outlet device (100) provided in the consumer premise; and
a control device (200), wherein
the outlet device (100) comprises:
a plurality of feeding units (101) each connected to a load (50) and configured to supply power to the respective load (50);
a detection unit (110) configured to detect the amount of electric current flowing from a feeding unit (101) to the corresponding load (50),
a measurement unit (121) configured to measure the amount of power consumption of each load (50) depending on the amount of electric current flowing detected by the detection unit (110); and
an analyzing unit (122) configured to acquire a frequency pattern derived from the time waveform of the amount of electric current detected by the detection unit (110), wherein
the control device (200) comprises:
a first storage unit (241) configured to store the frequency pattern of each load (50) associating with load identification information for identifying the load (50); and
a search unit (231) configured to search the load identification information corresponding to the frequency pattern acquired by the analyzing unit (122) from the first storage unit (241), wherein the control device is configured to perform the following functions when a new load (50) has been connected and the detection unit (110) has detected the amount of electric current flowing from the feeding unit (101) to the new load (50) and the analyzing unit (122) has acquired a frequency pattern derived from the time waveform of the amount of electric current detected by the detection unit (110), and the search unit (231) has searched the load identification information corresponding to the frequency pattern acquired by the anaylzing unit (122) from the first storage unit (241) and has detected that the load identification information is unkown to the first storage unit (241):
the search unit (231) is configured to transmit, to an outside device (300) different from the control device (200), the frequency pattern or information equivalent to the frequency pattern, such as a consumption current waveform, and to receive corresponding load identification information from the outside device (300), and
the outlet device (100) is configured to transmit the frequency pattern acquired by the analyzing unit (122) and the amount of power consumption measured by measurement unit (121) to the control device (200) in predetermined time intervals.

2. The power consumption measurement system (10) according to claim 1, wherein:
the analyzing unit (122) is configured to acquire the frequency pattern by converting a time waveform of the amount of electric current detected by the detection unit (110) to a frequency domain.

3. The power consumption measurement system (10) according to claim 2, comprising: a second storage unit (242) configured to store the amount of power consumption measured by the measurement unit (121), associating with the load identification information searched by the search unit (231) or the load identification information received from the outside device (300) and the time information indicating the current time.

4. The power consumption measurement system (10) according to claim 3, comprising:
a display control unit (233) configured to control so as to display the amount of power consumption, the load identification information, and the time information stored by the second storage (242) unit associated with each other.

5. The power consumption measurement system (10) according to claim 2, wherein
the first storage unit (241) and the search unit (231) are provided in the control device (200) within the consumer premise.

6. A power consumption measuring method for measuring the amount of power consumption of a plurality of loads (50) provided in a consumer premise, in a power consumption measurement system (10) including an outlet device (100) provided in the consumer premise and a control device (200) comprising:
a step of supplying, by a plurality of feeding units (101) in the outlet device (100), power to each load (50), each load (50) being connected to a feeding unit (101);
a step of detecting, by the outlet device (100), the amount of electric current flowing from the outlet device (100) to the load (50);
a step of measuring, by the outlet device (100), the amount of power consumption of each load (50) depending on the amount of electric current detected by the step of detecting;
a step of acquiring, by the outlet device (100), a frequency pattern derived from the time waveform of the amount of electric current detected by the step of detecting;
a step of storing in a first storage unit (241), by the control device (200), the frequency pattern of each load (50) associating with load identification information for identifying the load (50); and, when a new load (50) has been connected and the detection unit (110) has detected the amount of electric current flowing from the feeding unit (101) to the new load (50) and the analyzing unit (122) has acquired a frequency pattern derived from the time waveform of the amount of electric current detected by the detection unit (110), and the search unit (231) has searched the load identification information corresponding to the frequency pattern acquired by the anaylzing unit (122) from the first storage unit (241) and the control device (200) has detected that the load identification information is unkown to the first storage unit (241), a step of transmitting, from the control device (200) to an outside device (300) different from the control device (200), the frequency pattern or information equivalent to the frequency pattern, such as a consumption current waveform, and receiving, at the control device (200), corresponding load identification information from the outside device (300); and
a step of transmitting the frequency pattern acquired by the step of acquiring and the amount of power consumption measured by the step of measuring to the control device (200) in predetermined time intervals.

## Patentansprüche

1. Leistungsaufnahmemesssystem (10) zum Messen der Leistungsaufnahmemenge mehrerer Lasten (50), die an einem Verbraucherstandort vorgesehen sind, das Folgendes umfasst:
eine Ausgabevorrichtung (100), die an dem Verbraucherstandort vorgesehen ist; und
eine Steuervorrichtung (200), wobei
die Ausgabevorrichtung (100) Folgendes umfasst:
mehrere Zuführeinheiten (101), von denen jede mit einer Last (50) verbunden ist und dazu ausgelegt ist, Leistung an die jeweilige Last (50) zu liefern;
eine Detektionseinheit (110), die dazu ausgelegt ist, die Menge an elektrischem Strom, die aus einer Zuführeinheit (101) zu der entsprechenden Last (50) fließt, zu detektieren,
eine Messeinheit (121), die dazu ausgelegt ist, die Leistungsaufnahmemenge jeder Last (50) in Abhängigkeit von der Menge an elektrischem Strom, die fließt und durch die Detektionseinheit (110) detektiert wird, zu messen; und
eine Analyseeinheit (122), die dazu ausgelegt ist, ein Frequenzmuster zu erfassen, das aus dem Zeitwellenform der Menge an elektrischem Strom, die durch die Detektionseinheit (101) detektiert wird, abgeleitet ist, wobei
die Steuervorrichtung (200) Folgendes umfasst:
eine erste Speichereinheit (241), die dazu ausgelegt ist, das Frequenzmuster jeder Last (50), die Lastidentifikationsinformationen zum Identifizieren der Last (59) zugeordnet ist, zu speichern; und
eine Sucheinheit (231), die dazu ausgelegt ist, die Lastidentifikationsinformationen, die dem Frequenzmuster entsprechen, das durch die Analyseeinheit (122) aus der ersten Speichereinheit (241) erfasst wird, zu suchen, wobei
die Steuervorrichtung dazu ausgelegt ist, die folgenden Funktionen auszuführen, wenn eine neue Last (50) angeschlossen worden ist, die Detektionseinheit (110) die Menge an elektrischem Strom, der aus der Zuführeinheit (101) zu der neuen Last (50) fließt, detektiert hat, die Analyseeinheit (122) ein Frequenzmuster, das aus der Zeitwellenform der durch die Detektionseinheit (110) detektierten Menge an elektrischem Strom abgeleitet ist, erfasst hat und die Sucheinheit (231) die Lastidentifikationsinformationen, die dem durch die Analyseeinheit (122) aus der ersten Speichereinheit (241) erfassten Frequenzmuster entsprechen, gesucht hat und detektiert hat, dass die Lastidentifikationsinformationen der ersten Speichereinheit (241) unbekannt sind:
die Sucheinheit (231) ist dann dazu ausgelegt, das Frequenzmuster oder ein Informationsäquivalent zu dem Frequenzmuster wie beispielsweise eine Verbrauchsstromwellenform an eine äußere Vorrichtung (300), die sich von der Steuervorrichtung (200) unterscheidet, zu senden und
entsprechende Lastidentifikationsinformationen von der äußeren Vorrichtung (300) zu empfangen, und
die Ausgabevorrichtung (100) ist dann dazu ausgelegt, das von der Analyseeinheit (122) erfasste Frequenzmuster und die von der Messeinheit (121) gemessene Leistungsaufnahmemenge in vorbestimmten Zeitintervallen an die Steuervorrichtung (200) zu senden.

2. Leistungsaufnahmemesssystem (10) nach Anspruch 1, wobei:
die Analyseeinheit (122) dazu ausgelegt ist, das Frequenzmuster durch Umwandeln einer Zeitwellenform der Menge an elektrischem Strom, die von der Detektionseinheit (110) detektiert wird, in einen Frequenzbereich zu erfassen.

3. Leistungsaufnahmemesssystem (10) nach Anspruch 2, das Folgendes umfasst: eine zweite Speichereinheit (242), die dazu ausgelegt ist, die Leistungsaufnahmemenge, die von der Messeinheit (121) gemessen wird, zugeordnet zu den von der Sucheinheit (231) gesuchten Lastidentifikationsinformationen oder den aus der äußeren Vorrichtung (300) empfangenen Lastidentifikationsinformationen und den Zeitinformationen, die die aktuelle Zeit angeben, zu speichern.

4. Leistungsaufnahmemesssystem (10) nach Anspruch 3, das Folgendes umfasst:
eine Anzeigesteuereinheit (233), die dazu ausgelegt ist, so zu steuern, dass die Leistungsaufnahmemenge, die Lastidentifikationsinformationen und die Zeitinformationen, die durch die zweite Speichereinheit (242) gespeichert sind, einander zugeordnet angezeigt werden.

5. Leistungsaufnahmemesssystem (10) nach Anspruch 2, wobei
die erste Speichereinheit (241) und die Sucheinheit (231) in der Steuervorrichtung (200) an dem Verbraucherstandort vorgesehen sind.

6. Leistungsaufnahmemessverfahren zum Messen der Leistungsaufnahmemenge mehrerer Lasten (50), die an einem Verbraucherstandort vorgesehen sind, in einem Leistungsaufnahmemesssystem (10), das eine Ausgabevorrichtung (100), die an dem Verbraucherstandort vorgesehen ist, und eine Steuervorrichtung (200) enthält, wobei das Verfahren Folgendes umfasst:
einen Schritt eines Lieferns von Leistung durch mehrere Zuführeinheiten (101) in der Ausgabevorrichtung (100) an jede Last (50), wobei jede Last (50) mit einer Zuführeinheit (101) verbunden ist;
einen Schritt eines Detektierens der Menge an elektrischem Strom, die aus einer Ausgabevorrichtung (100) zu der Last (50) fließt, durch die Ausgabevorrichtung (100);
einen Schritt eines Messens der Leistungsaufnahmemenge jeder Last (50) durch die Ausgabevorrichtung (100) in Abhängigkeit von der Menge an elektrischem Strom, die durch den Schritt des Detektierens detektiert wird;
einen Schritt eines Erfassens eines Frequenzmusters durch die Ausgabevorrichtung (100), das aus der Zeitwellenform der Menge an elektrischem Strom abgeleitet ist, die durch den Schritt des Detektierens detektiert wird;
einen Schritt eines Speicherns des Frequenzmusters jeder Last (50) zugeordnet zu Lastidentifikationsinformationen zum Identifizieren der Last (59) in einer ersten Speichereinheit (241) durch die Steuervorrichtung (200);
und dann, wenn eine neue Last (50) angeschlossen worden ist, die Detektionseinheit (110) die Menge an elektrischem Strom, der aus der Zuführeinheit (101) zu der neuen Last (50) fließt, detektiert hat, die Analyseeinheit (122) ein Frequenzmuster, das aus der Zeitwellenform der durch die Detektionseinheit (110) detektierten Menge an elektrischem Strom abgeleitet ist, erfasst hat und die Sucheinheit (231) die Lastidentifikationsinformationen, die dem durch die Analyseeinheit (122) aus der ersten Speichereinheit (241) erfassten Frequenzmuster entsprechen, gesucht hat und die Steuervorrichtung (200) detektiert hat, dass die Lastidentifikationsinformationen der ersten Speichereinheit (241) unbekannt sind,
einen Schritt eines Sendens des Frequenzmusters oder eines Informations-äquivalents wie beispielsweise einer Verbrauchsstromwellenform aus der Steuervorrichtung (200) an eine äußere Vorrichtung (300), die sich von der Steuervorrichtung (200) unterscheidet,
und eines Empfangens entsprechender Lastidentifikationsinformationen aus der äußeren Vorrichtung (300) bei der Steuervorrichtung (200); und
einen Schritt eines Sendens des durch den Schritt des Erfassens erfassten Frequenzmusters und der durch den Schritt des Messens gemessenen Leistungsaufnahmemenge an die Steuervorrichtung (200) in vorbestimmten Zeitintervallen.

## Revendications

1. Système de mesure de la consommation d'électricité (10) pour mesurer une quantité d'électricité consommée par une pluralité de charges (50) présentes dans les locaux d'un consommateur, comprenant :
un dispositif de prise murale (100) prévu dans les locaux du consommateur ; et
un dispositif de commande (200), où
le dispositif de prise murale (100) comprend :
une pluralité d'unités d'alimentation (101) connectées chacune à une charge (50) et configurées pour alimenter la charge respective (50) en électricité ;
une unité de détection (110) configurée pour détecter la quantité de courant électrique circulant entre une unité d'alimentation (101) et la charge (50) correspondante,
une unité de mesure (121) configurée pour mesurer la quantité d'électricité consommée par chaque charge (50) en fonction de la quantité de courant électrique circulant détectée par l'unité de détection (110) ;et
une unité d'analyse (122) configurée pour acquérir un motif de fréquence dérivé de la forme d'onde temporelle de la quantité de courant électrique détectée par l'unité de détection (110), où
le dispositif de commande (200) comprend :
une première unité de stockage (241) configurée pour stocker le motif de fréquence de chaque charge (500) conjointement avec une information d'identification de charge pour identifier la charge (50) ; et
une unité de recherche (231) configurée pour chercher l'information d'identification de charge correspondant au motif de fréquence acquis par l'unité d'analyse (122) dans la première unité de stockage (241), où
le dispositif de commande est configuré pour exécuter les fonctions suivantes quand une nouvelle charge (50) a été connectée et l'unité de détection (110) a détecté la quantité de courant électrique circulant de l'unité d'alimentation (101) à la nouvelle charge (50) et l'unité d'analyse (122) a acquis un motif de fréquence dérivé de la forme d'onde temporelle de la quantité de courant électrique détectée par l'unité de détection (110), et l'unité de recherche (231) a recherché l'information d'identification de charge correspondant au motif de fréquence acquis par l'unité d'analyse (122) dans la première unité de stockage (241) et a détecté que l'information d'identification de charge n'est pas connue par la première unité de stockage (241) :
l'unité de recherche (231) est configurée pour transmettre à un dispositif extérieur (300) différent du dispositif de commande (200) le motif de fréquence ou des informations équivalentes au motif de fréquence, telles qu'une forme d'onde de courant consommé, et pour recevoir des informations d'identification de charge correspondantes en provenance du dispositif extérieur (300), et
le dispositif de prise murale (100) est configuré pour transmettre le motif de fréquence acquis par l'unité d'analyse (122) et la quantité d'électricité consommée mesurée par l'unité de mesure (121) au dispositif de commande (200) à intervalles de temps prédéterminés.

2. Système de mesure de la consommation d'électricité (10) selon la revendication 1, où :
l'unité d'analyse (122) est configurée pour acquérir le motif de fréquence en convertissant une forme d'onde temporelle de la quantité de courant électrique détectée par l'unité de détection (110) en un domaine fréquentiel.

3. Système de mesure de la consommation d'électricité (10) selon la revendication 2, comprenant : une seconde unité de stockage (242) configurée pour stocker la quantité d'électricité consommée mesurée par l'unité de mesure (121) conjointement avec l'information d'identification de charge recherchée par l'unité de recherche (231) ou l'information d'identification de charge reçue en provenance du dispositif extérieur (300) et une information temporelle indiquant l'heure actuelle.

4. Système de mesure de la consommation d'électricité (10) selon la revendication 3, comprenant:
une unité de commande d'affichage (233) configurée pour commander l'affichage de la quantité d'électricité consommée, de l'information d'identification de charge et de l'information temporelle stockées conjointement dans la seconde unité de stockage (242).

5. Système de mesure de la consommation d'électricité (10) selon la revendication 2, où :
la première unité de stockage (241) et l'unité de recherche (231) sont prévues dans le dispositif de commande (200) dans les locaux du consommateur.

6. Procédé de mesure de consommation d'électricité pour mesurer la quantité d'électricité consommée par une pluralité de charges (50) présentes dans les locaux d'un consommateur, dans un système de mesure de la consommation d'électricité (10) comprenant un dispositif de prise murale (100) prévu dans les locaux du consommateur et un dispositif de commande (200) comprenant :
une étape d'alimentation de chaque charge (50) en électricité par l'intermédiaire d'une pluralité d'unités d'alimentation (101) dans le dispositif de prise murale (100), chaque charge (50) étant connectée à une unité d'alimentation (101) ;
une étape de détection, par le dispositif de prise murale (100), de la quantité de courant électrique circulant entre le dispositif de prise murale (100) et la charge (50) ;
une étape de mesure, par le dispositif de prise murale (100), de la quantité d'électricité consommée par chaque charge (50) en fonction de la quantité de courant électrique circulant détectée lors de l'étape de détection ;
une étape d'acquisition, par le dispositif de prise murale (100), d'un motif de fréquence dérivé de la forme d'onde temporelle de la quantité de courant électrique détectée lors de l'étape de détection ;
une étape de stockage, par le dispositif de commande (200), dans une première unité de stockage (241), du motif de fréquence de chaque charge (50) conjointement avec une information d'identification de charge pour identifier la charge (50) ;
et quand une nouvelle charge (50) a été connectée et l'unité de détection (110) a détecté la quantité de courant électrique circulant de l'unité d'alimentation (101) à la nouvelle charge (50) et l'unité d'analyse (122) a acquis un motif de fréquence dérivé de la forme d'onde temporelle de la quantité de courant électrique détectée par l'unité de détection (110), et l'unité de recherche (231) a recherché l'information d'identification de charge correspondant au motif de fréquence acquis par l'unité d'analyse (122) dans la première unité de stockage (241) et le dispositif de commande (200) a détecté que l'information d'identification de charge n'est pas connue par la première unité de stockage (241) :
une étape de transmission, par le dispositif de commande (200) à un dispositif extérieur (300) différent du dispositif de commande (200), du motif de fréquence ou d'informations équivalentes au motif de fréquence, telles qu'une forme d'onde de courant consommé, et de réception, par le dispositif de commande (200) des informations d'identification de charge correspondantes en provenance du dispositif extérieur (300), et
un étape de transmission du motif de fréquence acquis lors de l'étape d'acquisition et de la quantité d'électricité consommée mesurée lors de l'étape de mesure au dispositif de commande (200) à intervalles de temps prédéterminés.
